# EUROPÄISCHE PATENTANMELDUNG

(11) **EP 2 450 974 A1**
(43) Veröffentlichungstag der Anmeldung: **09.05.2012**
(21) Anmeldenummer: 10189897.1
(22) Anmeldetag: 03.11.2010
(51) Int. Cl.: H01L 41/193, H01L 41/26

(54) **Polymerschichtenverbund mit Ferroelektret-Eigenschaften und Verfahren zu dessen Herstellung**

(71) Anmelder: Bayer MaterialScience AG, 51368 Leverkusen (DE)
(72) Erfinder: Jenninger, Dr., Werner, 50677, Koeln (DE); Lovera-Prieto, Dr., Deliani, 51375, Leverkusen (DE)

(57) **Zusammenfassung**

Die vorliegende Erfindung betrifft einen Polymerschichtstruktur mit Ferroelektret-Eigenschaften, umfassend eine durchgehende erste Polymerschicht (1) und eine durchgehende zweite Polymerschicht (2), wobei die erste und die zweite Polymerschicht (1, 2) durch zwischen den durchgehenden Polymerschichten (1, 2) angeordnete Verbindungsabschnitte (3) unter Bildung von Hohlräumen (4) miteinander verbunden sind. Erfindungsgemäß ist die Polymerschichtstruktur als integrales Extrusionsbauteil ausgebildet.

## Beschreibung

Die vorliegende Erfindung betrifft eine Polymerschichtstruktur mit Ferroelektret-Eigenschaften mit einer ersten durchgehenden Polymerschicht und einer zweiten durchgehenden Polymerschicht, wobei die erste und die zweite Polymerschicht durch geneigt zu den durchgehenden Polymerschichten angeordnete Verbindungsabschnitte unter Bildung von Hohlräumen miteinander verbunden sind. Ferner betrifft die vorliegende Erfindung ein Verfahren zur Herstellung eines erfindungsgemäßen Polymerschichtverbundes und ein piezoelektrisches Element, umfassend einen erfindungsgemäßen Polymerschichtverbund.

Wegen ihrer vorteilhaften und gezielt einstellbaren Eigenschaften, wie zum Beispiel geringes Gewicht, thermische Leitfähigkeit, mechanische Verformbarkeit, elektrische Eigenschaften sowie Barrierefunktionen werden Polymere und Polymerverbundstoffe in einer Vielzahl von kommerziellen Anwendungen eingesetzt. Sie werden beispielsweise als Verpackungsmaterial für Lebensmittel oder sonstige Güter, als Konstruktions- oder Isolationsmaterialien beispielsweise im Bauwesen oder im Fahrzeugbau verwendet. Funktionspolymere gewinnen in zunehmendem Maße aber auch als aktive Komponenten in Sensor- oder Aktoranwendungen an Bedeutung.

Ein wichtiges Anwendungskonzept bezieht sich dabei auf den Einsatz der Polymere als elektromechanische oder piezoelektrische Wandler. Piezoelektrische Materialien sind in der Lage, einen mechanischen Druck in ein elektrisches Spannungssignal umzuwandeln. Umgekehrt kann ein an das piezoelektrische Material angelegtes elektrisches Feld in eine Änderung der Wandlergeometrie transformiert werden. Piezoelektrische Materialien werden bereits in einer Vielzahl von Anwendungen als aktive Komponenten integriert. Hierzu gehören beispielsweise strukturierte Drucksensoren für Tastaturen oder Touchpads, Beschleunigungssensoren, Mikrofone, Lautsprecher, Ultraschallwandler für Anwendungen in der Medizintechnik, der Meerestechnik oder zur Materialprüfung. In der Patentanmeldung WO 2006/053528 A1 ist beispielsweise ein elektroakustischer Wandler auf Basis eines piezoelektrischen Elements aus Polymerfolien beschrieben.

In den letzten Jahren steht zunehmend eine neue Klasse piezoelektrischer Polymere, die sogenannten Ferroelektrete, im Interesse der Forschung. Die Ferroelektrete werden auch Piezoelektrete genannt. Ferroelektrete sind Polymermaterialien mit einer Hohlraumstruktur, die elektrische Ladungen über lange Zeiträume speichern können. Die bisher bekannten Ferroelektrete weisen eine zelluläre Hohlraumstruktur auf und sind entweder als geschäumte Polymerfolien oder als Mehrschichtsysteme aus Polymerfolien oder Polymergeweben ausgebildet. Sind elektrische Ladungen entsprechend ihrer Polarität auf den unterschiedlichen Oberflächen der Hohlräume verteilt, stellt jeder geladene Hohlraum einen elektrischen Dipol dar. Werden die Hohlräume nun deformiert, bedingt dies eine Änderung der Dipolgröße und führt zu einem Stromfluss zwischen äußeren Elektroden. Die Ferroelektrete können eine piezoelektrische Aktivität zeigen, die der anderer Piezoelektrika vergleichbar ist.

Ferroelektrete sind für kommerzielle Anwendungen, beispielsweise für Sensor-, Aktor- und Generatorsysteme, weiterhin von zunehmendem Interesse. Für die Wirtschaftlichkeit ist dabei eine Anwendbarkeit eines Herstellungsverfahrens im industriellen Maßstab essentiell.

Ein Verfahren zur Herstellung geschäumter Ferroelektret-Polymerfolien ist das direkte physikalische Schäumen einer homogenen Folie mit superkritischen Flüssigkeiten, zum Beispiel mit Kohlendioxid. In der Veröffentlichung Advanced Functional Materials 17, 324-329 (2007), Werner Wirges, Michael Wegener, Olena Voronina, Larissa Zirkel und Reimund Gerhard-Multhaupt "Optimized preparation of elastically soft, highly piezoelectric, cellular ferroelectrets from nonvoided poly(ethylene terephthalate) films", und in Applied Physics Letters 90, 192908 (2007), P. Fang, M. Wegener, W. Wirges, and R. Gerhard L. Zirkel "Cellular polyethylenenaphthalate ferroelectrets: Foaming in supercritical carbon dioxide, structural and electrical preparation, and resulting piezoelectricity", ist dieses Verfahren mit Polyestermaterialien sowie in Applied Physics A: Materials Science & Processing 90, 615-618 (2008), O. Voronina, M. Wegener, W. Wirges, R. Gerhard, L. Zirkel und H. Münstedt "Physical foaming of fluorinated ethylene-propylene (FEP) copolymers in supercritical carbon dioxide: single film fluoropolymer piezoelectrets" für ein Fluorpolymer FEP (Fluorinated Ethylene-Propylene Copolymer) beschrieben worden.

Die geschäumten Polymerfolien haben allerdings den Nachteil, dass sich eine breite Verteilung der Bläschengröße ergeben kann. Dadurch können bei dem anschließenden Aufladungsschritt nicht alle Blasen gleichmäßig gut aufgeladen werden.

Bei den Ferroelektret-Mehrschichtsystemen sind unter anderem Anordnungen aus harten und weichen Schichten und dazwischen eingebrachten Ladungen bekannt. In "Double-layer electret transducer", Journal of Electrostatics, Vol. 39, pp. 33-40, 1997, R. Kacprzyk, A. Dobrucki, and J. B. Gajewski, sind Mehrfachschichten aus festen Materialien mit stark unterschiedlichen Elastizitätsmodulen beschrieben. Diese haben jedoch den Nachteil, dass diese Schichtsysteme nur einen relativ geringen piezoelektrischen Effekt zeigen.

Neueste Entwicklungen auf dem Gebiet der Ferroelektrete sehen strukturierte Polymerschichten vor. In mehreren Veröffentlichungen aus den letzten Jahren sind Mehrschichtsysteme aus geschlossenen äußeren Schichten und einer porösen oder perforierten Mittelschicht beschrieben. Hierzu gehören die Artikel von Z. Hu und H. von Seggern, "Air-breakdown charging mechanism of fibrous polytetrafluoroethylene films", Journal of Applied Physics, Vol. 98, paper 014108, 2005 und "Breakdown-induced polarization buildup in porous fluoropolymer sandwiches: A thermally stable piezoelectret", Journal of Applied Physics, Vol. 99, paper 024102, 2006, sowie die Veröffentlichung von H.C. Basso, R.A.P. Altafilm, R.A.C. Altafilm, A. Mellinger, Peng Fang, W. Wirges und R. Gerhard "Three-layer ferroelectrets from perforated Teflon-PTFE films fused between two homogeneous Teflon -FEP films" IEEE, 2007 Annual Report Conference on Electrical Insulation and Dielectric Phenomena, 1-4244-1482-2/07, 453-456 (2007) und der Artikel von Jinfeng Huang, Xiaoqing Zhang, Zhongfu Xia, and Xuewen Wang "Piezoelectrets from laminated sandwiches of porous polytetrafluoroethylene films and nonporous fluoroethylenepropylene films", Journal of Applied Physics, Vol. 103, paper 084111, 2008.

Die Schichtsysteme mit einer porösen oder perforierten Mittelschicht haben gegenüber den vorstehend beschriebenen Systemen häufig größere Piezokonstanten. Dabei lassen sich die Mittelschichten jedoch manchmal nicht zuverlässig mit den festen Außenschichen laminieren. Darüber hinaus ist die Perforation der Mittelschicht in der Regel sehr zeitaufwendig.

Eine Herstellungsmethode für Ferroelektrete mit röhrenförmigen Hohlräumen homogener Größe und Struktur wurde von R. A. P. Altafim, X. Qiu, W. Wirges, R. Gerhard, R. A. C. Altafim, H.C. Basso, W. Jenninger und J. Wagner in dem Artikel "Template-based fluoroethylenepropylene piezoelectrets with tubular channels for transducer applications", Journal of Applied Physics 106, 014106 (2009), beschrieben. Bei dem dort beschriebenen Verfahren wird zunächst eine Sandwichanordnung zweier FEP-Folien und einer dazwischen eingelegten PTFE-Maskenfolie bereitgestellt. Der gebildete Folienstapel wird laminiert, die FEP-Folien miteinander verbunden und nachfolgend die Maskenfolie unter Freigabe der Hohlräume entfernt.

WO 2010/066348 A2 offenbart schließlich ein Verfahren zur Herstellung von Zwei- oder Mehrschicht-Ferroelektreten mit definierten Hohlräumen durch Strukturieren mindestens einer ersten Oberfläche einer ersten Polymerfolie unter Ausbildung eines Höhenprofils, Auflegen mindestens einer zweiten Polymerfolie auf die in einem ersten Schritt gebildete strukturierte Oberfläche der ersten Polymerfolie, Verbinden der Polymerfolien zu einem Polymerfolienverbund unter Ausbildung von Hohlräumen und die elektrische Aufladung der inneren Oberflächen der ausgebildeten Hohlräume mit entgegengesetzten elektrischen Ladungen. Gegenstand der Patentanmeldung sind weiterhin Ferroelektret-Mehrschichtverbunde, gegebenenfalls hergestellt nach den erfindungsgemäßen Verfahren umfassend mindestens zwei übereinander angeordnete und miteinander verbundene Polymerfolien, wobei zwischen den Polymerfolien Hohlräume ausgebildet sind. Zudem betrifft die Patentanmeldung ein piezoelektrisches Element enthaltend einen erfindungsgemäßen Ferroelektret-Mehrschichtverbund.

Allen vorstehend beschriebenen Verfahren zur Herstellung von Ferroelektreten ist gemein, dass sie, da die herzustellenden Ferroelektrete aus einer Vielzahl von Einzelkomponenten gebildet werden, vergleichsweise aufwändig durchzuführen sind, was zu hohen Produktkosten führt.

Der Erfindung liegt daher die Aufgabe zu Grunde, eine Ferroelektret-Polymerschichtstruktur sowie ein Verfahren zur Herstellung von Ferroelektreten bereitzustellen, mit welchem definierte Ferroelektret-Hohlraumstrukturen erzeugt werden können, wobei das Verfahren insbesondere einfach und kostengünstig auch im großtechnischen und industriellen Maßstab durchführbar sein soll.

Diese Aufgabe wird erfindungsgemäß durch einen Polymerschichtverbund gemäß dem Anspruch 1 und ein Verfahren gemäß Anspruch 10 gelöst. Vorteilhafte Weiterbildungen sind in den Unteransprüchen angegeben.

Die vorliegende Erfindung betrifft also eine Polymerschichtstruktur mit Ferroelektret-Eigenschaften. Erfindungsgemäß umfasst die Polymerschichtstruktur eine durchgehende erste Polymerschicht und eine durchgehende zweite Polymerschicht, wobei die erste und die zweite Polymerschicht durch zwischen den durchgehenden Polymerschichten angeordnete Verbindungsabschnitte unter Bildung von Hohlräumen miteinander verbunden sind. Erfindungsgemäß ist die Polymerschichtstruktur dadurch gekennzeichnet, dass sie als integrales Extrusionsbauteil ausgebildet ist.

Unter einem "integralen Extrusionsbauteil" im Sinne der vorliegenden Erfindung werden solche Bauteile verstanden, welche ihre für den jeweiligen Einsatzzweck erforderliche Bauform unmittelbar durch den Extrusionsschritt erlangen, ohne dass, abgesehen von evtl. notwendiger Nachbearbeitung zur Sicherstellung einer gleichbleibend hohen Produktqualität, weitere Formungsschritte oder Fügeschritte nötig sind. Insbesondere erfordert ein integrales Extrusionsbauteile keine Verbindung einzelner Bauteilkomponenten im Anschluss an die Extruison.

Im Rahmen der vorliegenden Erfindung bedeuten Ferroelektret-Eigenschaften, dass innerhalb von Hohlräumen einander entgegengesetzte elektrische Ladungen auf gegenüberliegenden Oberflächen des Hohlraums angeordnet sind. Wie bereits ausgeführt, stellt jeder Hohlraum damit einen elektrischen Dipol dar. Bei einer Deformation des Hohlraums kommt es zu einer Änderung der Dipolgröße und es kann ein elektrischer Strom zwischen entsprechend angeschlossenen äußeren Elektroden fließen.

Der besondere Vorteil der erfindungsgemäßen Polymerschichtstruktur besteht darin, dass sie mit einem etablierten Produktionsverfahren, nämlich mittels Extrusion, auf kostengünstige Weise mit einem hohen Automatisierungsgrad hocheffizient hergestellt werden kann. Bei der Formung der Polymerschichtstruktur, insbesondere bei der Formung der gewünschten Hohlraumquerschnitte, erlaubt die Extrusion einen hohen Grad an Designfreiheit. So kann mit einer entsprechenden Düsenform eine Vielzahl von Querschnittsgeometrien realisiert werden. Dabei versteht es sich, dass die Hohlräume verfahrensbedingt über die gesamte Erstreckung der extrudierten Polymerschichtstruktur tunnelartig mit konstantem Querschnitt, also als parallel angeordnete, lineare, durchgehende Kanäle, ausgebildet sind.

Die erste und die zweite Polymerschicht der Polymerschichtstruktur können mit variabler Dicke, insbesondere mit periodisch variierender Dicke ausgebildet sein. Nach einer bevorzugten Ausgestaltung der Erfindung sind die Dicken d1 und d2 der ersten und der zweiten Polymerschicht konstant. Unter dem Begriff "konstant" ist erfindungsgemäß zu verstehen, dass die Dicke aufgrund unvermeidlicher Schwankungen höchstens um ± 10% variiert, wobei Schwankungen um höchstens ± 5% der Dicke bevorzugt sind.

Die Querschnitte der Hohlräume können verschiedene geometrische Formen annehmen. Denkbar sind runde ebenso wie mehreckige Querschnitte, hier speziell viereckige, insbesondere quadratische Querschnitte.

Nach einer Ausgestaltung der Erfindung weisen die Hohlräume wenigstens teilweise einen trapezförmigen Querschnitt, insbesondere einen symmetrischen trapezförmigen Querschnitt mit gleichlangen Schenkeln, auf. Dabei ist bevorzugt, dass sämtliche Hohlräume einen, insbesondere symmetrisch, trapezförmigen Querschnitt aufweisen, wobei bei horizontal angeordneter Polymerschichtstruktur jeweils die längere Grundseite eines Trapezquerschnittes abwechselnd oberhalb und unterhalb der zugehörigen kürzeren Grundseite angeordnet ist. Anders ausgedrückt: die Trapezquerschnitte jeweils benachbarter Hohlräume lassen sich durch eine Punktspiegelung in einander überführen. Hierdurch können die die beiden durchgehenden Polymerschichten verbindenden Verbindungsabschnitte mit dünner Wandstärke ausgebildet werden, da so die Schenkel benachbarter Trapezquerschnitte parallel zueinander ausgerichtet werden können. Dies trägt zur gewünschten Strukturweichheit der Polymerschichtstruktur bei. Mit einer trapezoiden Anordnung der Hohlraumquerschnitte der vorstehend beschriebenen Art sind zudem jeweils benachbart angeordnete Verbindungsabschnitte spitzwinklig zueinander und zu den beiden Polymerschichten angeordnet. Dies trägt weiter zu der gewünschten Strukturweichheit bei, wodurch die Polymerschichtstruktur unter anderem gegenüber vergleichbaren Ferroelektret-Systemen mit rechtwinkligen Hohlraumquerschnitten eine größere piezoelektrische Konstante d₃₃ aufweist.

Nach einer weiteren Ausgestaltung der Erfindung beträgt die Dicke d1 der ersten Polymerschicht > 10 µm bis ≤ 250 µm und die Dicke d2 der zweiten Polymerschicht ≥ 10 µm bis ≤ 250 µm. Ferner ist bevorzugt, dass die als Länge der längeren Grundseite eines Trapezquerschnitts definierte Breite a ≥ 10 µm bis ≤ 5 mm, bevorzugt ≥ 100 µm bis ≤ 3 mm, beträgt. Die als Breite des Trapezquerschnitts auf halber Höhe definierte Breite b beträgt bevorzugt ≥ 10 µm bis ≤ 5 mm, bevorzugt ≥ 100 µm bis ≤ 3 mm, beträgt. Die Höhe h des Trapezquerschnitts beträgt bevorzugt > 10 µm bis ≤ 500 µm. Der zwischen der längeren Grundseite des Trapez Querschnitts und einem Schenkel eingeschlossene Winkel α beträgt bevorzugt ≥ 5° bis ≤ 80°.

Die vorstehend angegebenen Parameterbereiche ermöglichen optimale Ferroelektret-Eigenschaften und lassen sich durch eine entsprechende Auslegung der Extrusionsanlage, speziell der Extrusionsdüse, realisieren.

Nach einer weiteren Ausgestaltung der Erfindung umfasst die Polymerschichtstruktur ein Material, das ausgewählt ist aus der Gruppe umfassend Polycarbonat, perfluorierte oder teilfluorierte Polymere und Co-Polymere, Polytetrafluorethylen, Fluorethylenpropylen, Perfluoralkoxyethylen, Polyester, Polyethylenterephthalat, Polyethylennaphthalat, Polyimid, Polyetherimid, Polyether, speziell Polyphenylenether (PPE), Polymethyl(meth)acrylat, Cyclo-Olefin-Polymere, Cyclo-Olefin-Copolymere, Polyolefine, speziell Polypropylen, Polystyrol und/oder Mischungen daraus. Die Mischungen können homogen oder phasensepariert sein. Die erfindungsgemäß breite Materialauswahl kann vorteilhafterweise auch eine Anpassung auf bestimmte Anwendungen ermöglichen.

In einer weiteren Ausführungsform des erfindungsgemäßen Schichtenverbundes sind die tunnelartigen Hohlräume der durch Extrusion hergestellten Polymerschichtstruktur mit Gasen gefüllt, die ausgewählt sind aus der Gruppe umfassend Stickstoff (N₂), Distickstoffmonoxid (N₂O) und/oder Schwefelhexafluorid (SF₆). Durch die Gasbefüllung können vorteilhafterweise bei den erfindungsgemäßen Polymerschichtenverbunden durch Polung nochmals deutlich höhere Piezokonstanten erzielt werden. Um die Gasfüllung in der Polymerschichtstruktur einzuschließen, versteht es sich, dass die tunnelartigen Hohlräume stirnseitig zu verschließen sind.

In einer weiteren Ausführungsform der erfindungsgemäßen Polymerschichtstruktur umfasst die Polymerschichtstruktur weiterhin eine oder mehrere Elektroden. Insbesondere kann die erfindungsgemäße Polymerschichtstruktur auf den nach außen gerichteten Oberflächen der Polymerfolien mindestens teilweise eine leitende Beschichtung aufweisen. Diese leitenden Bereiche können als Elektroden genutzt werden. Die leitende Beschichtung, das heißt die Elektroden, können dabei flächig und/oder auch strukturiert aufgebracht werden. Eine strukturierte leitende Beschichtung kann beispielsweise als eine Aufbringung in Streifen oder in Gitterform ausgestaltet sein. Hierdurch kann zusätzlich die Empfindlichkeit des Polymerschichtverbundes beeinflusst und auf bestimmte Anwendungen angepasst werden.

Bei den ausgewählten Elektrodenmaterialien kann es sich um dem Fachmann bekannte leitfähige Materialien handeln. Erfindungsgemäß kommen hierfür beispielsweise Metalle, Metall-Legierungen, leitfähige Oligo- oder Polymere, wie zum Beispiel Polythiophene, Polyaniline, Polypyrrole, leitfähige Oxide, wie zum Beispiel Mischoxide wie ITO, oder mit leitfähigen Füllstoffen gefüllte Polymere in Frage. Als Füllstoffe für mit leitfähigen Füllstoffen gefüllte Polymere kommen beispielsweise Metalle, leitfähige Kohlenstoff basierte Materialien, wie zum Beispiel Ruß, Kohlenstoffnanoröhrchen (carbon nanotubes, CNTs) oder wiederum leitfähige Oligo- oder Polymere, in Frage. Der Füllstoffgehalt der Polymere liegt dabei oberhalb der Perkolationsschwelle, so dass die leitfähigen Füllstoffe durchgehende elektrisch leitfähige Pfade ausbilden.

Die Elektroden können durch an sich bekannte Verfahren, beispielsweise durch eine Metallisierung der Oberflächen, durch Sputtern, Aufdampfen, Chemical Vapor Deposition (CVD), Drucken, Rakeln, Lackschleudern (Spin-Coating), Aufkleben oder Aufdrücken einer leitenden Schicht in vorgefertigter Form oder durch eine Sprühelektrode aus einem leitenden Kunststoff realisiert werden. Die Elektroden können dabei strukturiert, beispielsweise in Streifen oder in Gitterform, ausgestaltet sein. Beispielsweise können nach einer Ausgestaltung der Erfindung die Elektroden auch derart strukturiert sein, dass die Polymerschichtstruktur als elektromechanischer Wandler aktive und passive Bereiche aufweist. Beispielsweise können die Elektroden derart strukturiert sein, dass, insbesondere in einem Sensor-Modus, die Signale ortsaufgelöst detektiert und/oder, insbesondere in einem Aktuator-Modus, die aktiven Bereiche gezielt angesteuert werden können. Dies kann beispielsweise dadurch erzielt werden, dass die aktiven Bereiche mit Elektroden versehen sind, wohingegen die passiven Bereiche keine Elektroden aufweisen.

Nach einer weiteren vorteilhaften Ausgestaltung der Erfindung ist zudem vorgesehen, dass zwei oder mehr Polymerschichtstrukturen mit gleich gepolter leitender Schicht, das heißt also Elektrode, verbunden werden können. Mit anderen Worten kann zwischen zwei erfindungsgemäßen Polymerschichtstrukturen eine Zwischenelektrode gebildet werden, die gegen die beiden Elektroden auf den dann äußeren Oberflächen geschaltet werden kann. Hierdurch können die Ferroelektret-Mehrschichtverbunde in Reihe geschaltet und der erzielbare piezoelektrische Effekt verdoppelt beziehungsweise vervielfacht werden.

Die erfindungsgemäßen Polymerschichtstrukturen enthalten bevorzugt zwei Elektroden. Bei elektromechanischen Wandlern mit mehr als zwei Elektroden kann es sich beispielsweise um Stapelaufbauten aus mehreren, vorzugsweise erfindungsgemäß hergestellten, Polymerschichtstruktur-Systemen handeln.

Die vorliegende Erfindung betrifft weiterhin ein Verfahren zur Herstellung eines erfindungsgemäßen Polymerschichtenverbundes, umfassend die Schritte:
(A) Bereitstellen eines Polymermaterials,
(B) Extrusion des Polymermaterials unter Bildung einer Polymerschichtstruktur umfassend eine durchgehende erste Polymerschicht und eine durchgehende zweite Polymerschicht, wobei die erste und die zweite Polymerschicht durch zwischen den durchgehenden Polymerschichten angeordnete Verbindungsabschnitte unter Bildung von Hohlräumen miteinander verbunden sind, und
(C) Elektrisches Aufladen der den Hohlräumen zugewandten Oberflächen der ersten und zweiten Polymerschicht.

In Bezug auf Details und Vorteile des erfindungsgemäßen Verfahrens wird auf die Ausführungen zur erfindungsgemäßen Polymerschichtstruktur verwiesen.

Nach einer Ausgestaltung des erfindungsgemäßen Verfahrens kann vor und/oder nach der elektrischen Aufladung der inneren Oberflächen der Hohlräume in Schritt (C) die Aufbringung von Elektroden an den äußeren Oberflächen der Polymerschichtstruktur erfolgen. Unter der Aufbringung von Elektroden an den äußeren Oberflächen wird die Bereitstellung einer leitenden Oberflächenbeschichtung in mindestens einem Teilbereich, insbesondere auf den nach außen gerichteten Oberflächen des Polymerschichtenverbunds verstanden.

In einer weiteren Ausführungsform des erfindungsgemäßen Verfahrens geschieht das elektrische Aufladen in Schritt (C) mittels direkter Aufladung oder Coronaentladung. Insbesondere kann das Aufladen durch eine Zweielektronen-Corona-Anordnung erfolgen. Dabei kann die Nadelspannung ≥ 20 kV, ≥ 25 kV und insbesondere ≥ 30 kV betragen. Die Aufladezeit kann dabei ≥ 20 s, ≥ 25 s und insbesondere ≥ 30 s betragen.

Unter "direkter Aufladung" ist hierbei ein Aufladen zu verstehen, wenn nach der Aufbringung von Elektroden auf den äußeren Oberflächen der Polymerschichtstruktur eine direkte Aufladung durch Anlegung einer elektrischen Spannung erfolgt. Vor der Aufbringung von Elektroden kann eine Polung der sich gegenüberliegenden Seiten der Hohlräume durch eine Corona-Entladung realisiert werden. Eine Corona-Behandlung ist vorteilhafterweise auch großtechnisch gut einsetzbar. Erfindungsgemäß ist es auch möglich, zunächst auf einer Oberfläche eine leitende Oberflächenbeschichtung bereitzustellen, die Polymerschichtstruktur dann aufzuladen und abschließend eine zweite Elektrode auf der gegenüberliegenden äußeren Oberfläche aufzubringen.

In einer weiteren Ausführungsform des erfindungsgemäßen Verfahrens werden vor dem elektrischen Aufladen in Schritt (C) die Hohlräume mit Gasen gefüllt, die ausgewählt sind aus der Gruppe umfassend Stickstoff, Stickstoffmonoxid und/oder Schwefelhexafluorid. Wie bereits geschildert, können durch die Gasbefüllung vorteilhafterweise bei den erfindungsgemäßen Polymerschichtenverbunden durch Polung nochmals deutlich höhere Piezokonstanten erzielt werden. Hierbei versteht es sich, dass die sich tunnelartig durch die Polymerschichtstruktur erstreckenden Hohlräume an ihren Stirnseiten verschlossen werden müssen, so dass das eingefüllte Gas in den Hohlräumen verbleibt.

Ein weiterer Gegenstand der vorliegenden Erfindung ist ein piezoelektrisches Element, umfassend eine erfindungsgemäße Polymerschichtstruktur. Dieses piezoelektrische Element kann besonders bevorzugt ein Sensor-, Aktor oder Generatorelement sein. Vorteilhafterweise kann die Erfindung in einer Vielzahl von verschiedensten Anwendungen im elektromechanischen und elektroakustischen Bereich, insbesondere im Bereich der Energiegewinnung aus mechanischen Schwingungen (Energy-Harvesting), der Akustik, des Ultraschalls, der medizinischen Diagnostik, der akustischen Mikroskopie, der mechanischen Sensorik, insbesondere Druck- Kraft- und/oder Dehnungssensorik, der Robotik und/oder der Kommunikationstechnologie verwirklicht werden.

Typische Beispiele hierfür sind Drucksensoren, elektroakustische Wandler, Mikrophone, Lautsprecher, Schwingungswandler, Lichtdeflektoren, Membrane, Modulatoren für Glasfaseroptik, pyroelektrische Detektoren, Kondensatoren und Kontrollsysteme und "intelligente" Fußböden.

Die vorliegende Erfindung wird unter Bezugnahme auf die nachfolgende Zeichnung weiter erläutert, ohne darauf beschränkt zu sein.

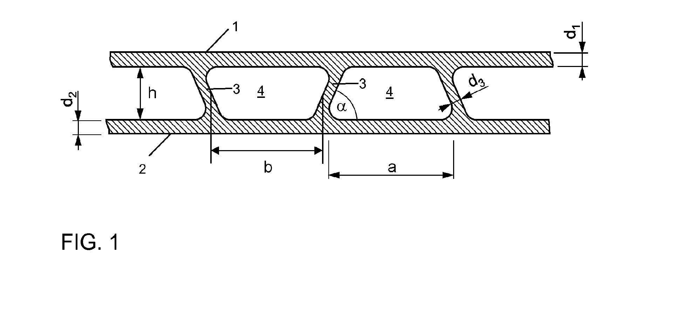

Figur 1 als einzige Figur zeigt eine extrudierte Polymerschichtstruktur mit trapezförmigen Hohlraumquerschnitten in einer Querschnittsansicht.

Figur 1 zeigt zum besseren Verständnis, insbesondere der Bemaßung, eine Polymerschichtstruktur mit Ferroelektret-Eigenschaften im Querschnitt. Die Polymerschichtstruktur der Figur 1 umfasst eine durchgehende erste Polymerschicht 1, vorliegend oben angeordnet, sowie eine durchgehende zweite Polymerschicht 2. Beide Polymerschichten 1,2 weisen eine im Wesentlichen konstante Dicke d1, d2, beispielsweise 50 µm, auf. Die beiden durchgehenden Polymerschichten 1,2 sind durch gewinkelte zu den durchgehenden Polymerschichten angeordnete Verbindungsabschnitte 3 miteinander verbunden. Deren Dicke d3 beträgt bevorzugt ebenfalls 50 µm. Hierdurch werden - dem Herstellungsverfahren entsprechend - tunnelartige Hohlräume 4 ausgebildet, wobei die die beiden Polymerschichten 1,2 verbindenden Verbindungsabschnitte 3 derart spitzwinklig zu den Polymerschichten 1, 2 und zueinander angeordnet sind, dass die Hohlräume 4 jeweils einen Querschnitt in Form eines symmetrischen Trapezes aufweisen. Dabei ist jeweils die längere Grundseite eines Trapezquerschnittes abwechselnd oberhalb und unterhalb der zugehörigen kürzeren Grundseite angeordnet, so dass jeweils benachbart angeordnete Trapezquerschnitte zueinander punktgespiegelt ausgerichtet sind. Der zwischen der längeren Grundseite (Basis) eines jeden Trapezquerschnittes und den angrenzenden Verbindungsabschnitten eingeschlossene Winkel α kann Werte zwischen 5 und 80° annehmen. Vorliegend beträgt der Winkel ca. 60°. Hierdurch wird eine gute Strukturweichheit und damit ein gute Eignung insbesondere als empfindlicher Sensor und als Generator (Energy harvesting) erreicht.

Nicht dargestellt ist ein Ausführungsbeispiel, bei dem mehrere der in Figur 1 dargestellten Polymerschichtstrukturen unter Ausbildung eines Stacks übereinander gestapelt sind, wobei sich jeweils zugewandte durchgehende Polymerschichten benachbarter aufeinander gestapelter Polymerschichtstrukturen mit gleicher Polarisation aufgeladen sind. Zwischen den einzelnen Polymerschichtstrukturen sind jeweils Elektrodenschichten angeordnet, die von den durchgehenden Polymerschichten gleicher Polarisation kontaktiert werden.

## Patentansprüche

1. Polymerschichtstruktur mit Ferroelektret-Eigenschaften, umfassend eine durchgehende erste Polymerschicht (1) und
eine durchgehende zweite Polymerschicht (2),
wobei die erste und die zweite Polymerschicht (1, 2) durch zwischen den durchgehenden Polymerschichten (1, 2) angeordnete Verbindungsabschnitte (3) unter Bildung von Hohlräumen (4) miteinander verbunden sind,
**dadurch gekennzeichnet, dass**
die Polymerschichtstruktur als integrales Extrusionsbauteil ausgebildet ist.

2. Polymerschichtstruktur nach Anspruch 1,
**dadurch gekennzeichnet, dass**
die Dicken d1 und d2 der ersten und zweiten Polymerschicht (1, 2) konstant sind.

3. Polymerschichtstruktur nach Anspruch 1 oder 2,
**dadurch gekennzeichnet, dass**
die Hohlräume (4) wenigstens teilweise einen trapezförmigen Querschnitt aufweisen.

4. Polymerschichtstruktur nach Anspruch 3,
**dadurch gekennzeichnet, dass**
der Hohlräume (4) wenigstens teilweise einen symmetrischen trapezförmigen Querschnitt mit gleichlangen Trapezschenkeln aufweisen.

5. Polymerschichtstruktur nach Anspruch 3 und 4,
**dadurch gekennzeichnet, dass**
sämtliche Hohlräume (4) einen trapezförmigen Querschnitt aufweisen, wobei bei horizontal angeordneter Polymerschichtstruktur jeweils die längere Grundseite eines Trapezquerschnittes abwechselnd oberhalb und unterhalb der zugehörigen kürzeren Grundseite angeordnet ist.

6. Polymerschichtstruktur nach einem der Ansprüche 1 bis 5,
**dadurch gekennzeichnet, dass**
die Dicke d1 ≥ 10 µm bis ≤ 250 µm beträgt,
die Dicke d2 ≥ 10 µm bis ≤ 250 µm beträgt,
die Breite a ≥ 10 µm bis ≤ 5 mm beträgt,
die Breite b ≥ 10 µm bis ≤ 5 mm beträgt
die maximale Höhe h ≥ 10 µm bis ≤ 500 µm beträgt und/oder der Winkel α = 5° bis ≤ 80° beträgt.

7. Polymerschichtstruktur nach einem der Ansprüche 1 bis 6,
**dadurch gekennzeichnet, dass**
die Polymerschichtstruktur ein Material umfasst, das ausgewählt ist aus der Gruppe umfassend Polycarbonat, perfluorierte oder teilfluorierte Polymere und Co-Polymere, Polytetrafluorethylen, Fluorethylenpropylen, Perfluoralkoxyethylen, Polyester, Polyethylenterephthalat, Polyethylennaphthalat, Polyimid, Polyetherimid, Polyether, speziell Polyphenylenether (PPE), Polymethyl(meth)acrylat, Cyclo-Olefin-Polymere, Cyclo-Olefin-Copolymere, Polyolefine, speziell Polypropylen, Polystyrol und/oder Mischungen daraus.

8. Polymerschichtstruktur nach einem der Ansprüche 1 bis 7,
**dadurch gekennzeichnet, dass**
die Hohlräume (4) mit Gasen gefüllt sind, die ausgewählt sind aus der Gruppe umfassend Stickstoff, Distickstoffmonoxid und/oder Schwefelhexafluorid.

9. Polymerschichtstruktur nach einem der Ansprüche 1 bis 8,
**dadurch gekennzeichnet, dass**
der Polymerschichtstruktur eine oder mehrere Elektroden umfasst.

10. Verfahren zur Herstellung einer Polymerschichtstruktur,
**gekennzeichnet durch** folgende Verfahrensschritte:
(A) Bereitstellen eines Polymermaterials,
(B) Extrusion des Polymermaterials unter Bildung einer Polymerschichtstruktur umfassend eine durchgehende erste Polymerschicht (1) und eine durchgehende zweite Polymerschicht (2), wobei die erste und die zweite Polymerschicht (1, 2) **durch** zwischen den durchgehenden Polymerschichten (1, 2) angeordnete Verbindungsabschnitte unter Bildung von Hohlräumen (4) miteinander verbunden sind, und
(C) Elektrisches Aufladen der den Hohlräumen zugewandten Oberflächen der ersten und zweiten Polymerschicht (1, 2).

11. Verfahren nach Anspruch 10,
**dadurch gekennzeichnet, dass**
das elektrische Aufladen in Schritt (C) mittels direkter Aufladung oder Coronaentladung erfolgt.

12. Verfahren nach Anspruch 10 oder 11,
**dadurch gekennzeichnet, dass**
vor dem elektrischen Aufladen in Schritt (C) die Hohlräume mit Gasen gefüllt werden, die ausgewählt sind aus der Gruppe umfassend Stickstoff, Stickstoffmonoxid und/oder Schwefelhexafluorid.

13. Piezoelektrisches Element, umfassend einen Polymerschichtenverbund nach einem der Ansprüche 1 bis 9.
